# EUROPEAN PATENT SPECIFICATION

(11) **EP 0 664 666 B1**
(45) Date of publication and mention of the grant of the patent: **06.08.1997**
(21) Application number: 95100775.6
(22) Date of filing: 20.01.1995
(51) Int. Cl.: H05K 13/08, H05K 13/04

(54) **Method and mounting device for mounting components at specific positions**
Verfahren und Montagevorrichtung zum Befestigen von Komponenten in spezifischen Positionen
Procédé et dispositif de montage pour fixer des composants dans des positions spécifiques

(30) Priority: 21.01.1994 JP 5436/94
(43) Date of publication of application: 26.07.1995
(73) Proprietor: YAMAHA HATSUDOKI KABUSHIKI KAISHA, Iwata-shi Shizuoka-ken (JP)
(72) Inventor: Ota, Hiroyuki, Iwata-shi, Shizuoka-ken (JP)
(74) Representative: Grünecker, Kinkeldey, Stockmair & Schwanhäusser Anwaltssozietät

(56) References cited:
- EP-A- 0 578 136
- PATENT ABSTRACTS OF JAPAN vol. 17 no. 155 (M-1388) ,26 March 1993 & JP-A-04 322924

## Description

The present invention relates to a method for mounting components at specific positions, especially chip components onto a substrate such as a printed circuit board, the method comprising the steps of picking up the components through a plurality of attracting nozzle units, transferring the components and placing the same in a detection area of an optical detecting means emitting light beams for detecting a projected width of the components, subjecting the components to a recognition process each, for recognizing the components and/or their positions relative to the attracting nozzle units, said recognition process including a preliminary rotation of the components and a main recognition process wherein projected width data are obtained under rotation of the components, and wherein the projections of the components attracted to the attracting nozzle units do not overlap with each other mounting the components at the desired positions.

The present invention relates also to a mounting device for mounting components at specific positions, especially chip components onto a substrate such as a printed circuit board, the mounting device comprising a moveable mounting head unit having a plurality of attracting nozzle units for picking up components from a component supply unit, an optical detecting means emitting light beams for detecting a projected width of said components, a control unit for controlling the mounting head unit including recognition control means for controlling recognition processes for recognizing the components and/or the positions thereof relative to the attracting nozzle units and wherein the projections of the components attracted to the attracting nozzle units do not overlap with each other.

So far has been generally known a chip component mounting machine on which a chip component such as electronic component like IC, etc., is attracted from the component feeding section by a chip component mounting head unit, transferred to a positioned printed substrate and mounted at a predetermined position on the printed substrate. This mounting machine usually has a head unit adapted for moving in the X axis and Y axis directions and an attracting nozzle adapted for moving in the Z axis direction and rotatable, and is provided with driving means for movement in various directions and for rotation. By controlling these driving means and negative pressure supplying means for the attacting nozzle by the controller section, the chip component is automatically attracted and mounted.

On such a mounting machine, the position of the component as attracted to the attracting nozzle has some degree of dispersion, and it is required to correct the mounting position acccording to the positional deviation of the component.

Therefore, as disclosed in JP-A-4 322 924, an apparatus has been known in which the head unit is provided with an optical detecting means composed of a parallel light beam emitting section and a light receiving section located opposite to each other on both sides of a domain through which the attracting nozzles are raised and lowered so that the projection of the chip component attracted to the attracting nozzle is detected and the chip component attracting state is recognized on the basis of this detection.

That is, as the component recognizing process, this apparatus detects the projection of the chip component (the range in which the parallel light beams are intercepted by the chip component) attracted to the attracting nozzle and positioned between the light beam emitting section and the light receiving section of the optical detecting means while rotating the attracting nozzle, and, on the basis of this detection data, obtains the values corresponding to the widths of the shorter side and the longer side of the chip component by examining the rotational position at which the projection width becomes a minimum and calculating the minimum value. The chip component attracting state is judged to be normal or not on the basis of the comparison of this value with the actual chip size, and, if normal, the positional deviation of the chip component center position is calculated and the mounting position correction is obtained from the detection data above.

Hereupon, although the head unit for the apparatus disclosed in the patent publication above is provided with only one attracting nozzle, apparatus has been proposed, to improve the mounting efficiency, whose head unit is provided with a plurality of attracting nozzles so that each attracting nozzle can attract and mount the respective component.

A method for mounting components and mounting device as indicated above is known from document EP-A-0 578 136. Such a mounting device comprises three attracting nozzle units which each allow movement and rotation of a respective attracted component, in order to detect the projected width thereof within a parallel light beam detection area.

When a plurality of attracting nozzles are provided as described above and the chip component attracting state of each attracting nozzle is examined by the component recognition using the optical detecting means above, the component recognition process for each attracted component has been so far started with some time lag so that the projection widths, etc., above can be easily calculated.

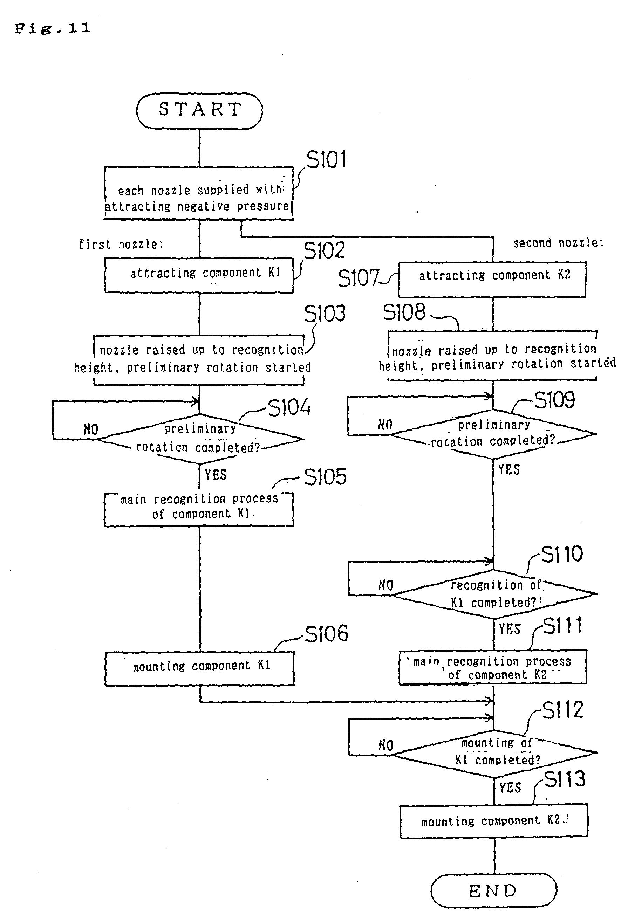

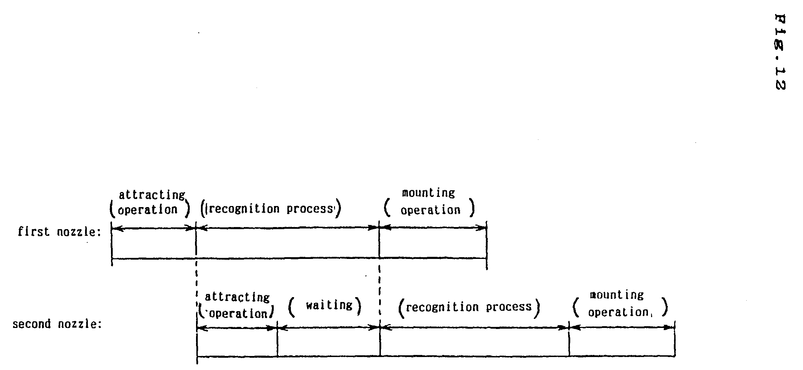

This process is shown in Fig.12 as a time chart for the case where the head unit is provided with two attracting nozzles. On the first attracting nozzle side, the attraction of a chip component, the component recognition by means of the optical detecting means above, and the mounting of the component are carried out successively. On the other hand, the attraction by the second attracting nozzle is started after the completion of the attraction by the first attracting nozzle, and the component attraction and component recognition are carried out successively also on the second attracting nozzle side. However, the component recognition on the second attracting nozzle side is started with a time lag after the completion of component recognition on the first attracting nozzle side that is, in the case where the component is still being recognized on the first attracting nozzle side when the attraction on the second attracting nozzle side is completed, the start of the component recognition on the second attracting nozzle side is retarded until the component recognition is completed on the first attracting nozzle side.

Therefore, a waiting period for time adjustment is produced between the attracting motion and the component recognition on the second attracting nozzle side, and, as the component recognition becomes longer on the first attracting nozzle side, this waiting period also becomes longer, which produces a time loss during the mouting time from attraction to mounting preventing desirable reduction of the mounting time.

It is therefore an objective of the present invention to provide an improved method and an improved mounting device of the afore-indicated type which allow an improved component recognition so as to shorten the components mounting time by reducing the time lag between the recognition processes of respective attracted components.

As regards the method, the afore-mentioned objective is performed, according to the present invention, in that the timing of the recognition processes for a plurality of components is adjusted by a timing adjusting means in response to each other, such that a recognition process for a first component overlaps at least partly a recognition process for another component.

Accordingly, the time lag between component recognitions at the respective attracting nozzles becomes smaller and the waiting time for time adjustments becomes shorter.

According to a preferred embodiment of the invention, the timing is adjusted in such a manner that while the recognition process for said first component is carried out, the preliminary rotation of at least another component is performed.

According to a further preferred embodiment, the timing of the main recognition processes for a plurality of components is adjusted such that said main recognition processes are performed in succession, said main recognition processes are not overlapping each other.

Accordingly, since a main recognition process of a first component merely overlaps the preliminary rotation of one or several other components and does not overlap other main recognition processes of other components, the time lag between component recognitions can be reduced, but the processing capacity of the calculating mean for calculating the projection width data can be relatively small, as the main recognition processes are performed in succession.

As regards the apparatus, the afore-mentioned objective is performed, according to the present invention, in that the control unit includes timing adjusting means for adjusting the timing of the recognition processes for a plurality of components in response to each other such that said recognition processes overlap each other at least partially.

According to a preferred embodiment, said timing adjusting means is adapted to adjust the timing of the recognition processes such that while the recognition process for a first component is performed, the preliminary rotation of at least another component is carried out.

According to a further preferred embodiment, the timing adjusting means is adapted to adjust the timing of a plurality of main recognition processes for a plurality of components such that the same are performed in succession.

The mounting device is therefore advantageous in that it can considerably reduce the component recognition period with a relatively small processing capacity of the control unit.

Further preferred embodiments of the present invention are laid down in further dependent claims.

Hereinafter, the present invention is illustrated and explained in greater detail by means of a preferred embodiment thereof in connection with accompanying drawings, wherein:
Figure 1 is a schematic plan view showing a chip component mounting machine having a component recognizing apparatus according to a preferred embodiment of this invention,
Figure 2 is a schematic front view of the chip component mounting machine according to figure 1,
Figure 3 is a front view showing the principal portions of a head unit of the component mounting machine according to figure 1, said head unit including two attracting nozzles for attracting components,
Figure 4 is a schematic plan view of a laser unit for detecting components, said laser unit being provided on the head unit shown in figure 1,
Figure 5 is a block diagram showing the control system of the chip component mounting machine according to figure 1,
Figure 6 is a flow chart showing an example of the control of the mounting operation performed by the mounting machine according to figure 1,
Figure 7 is a flow chart showing the routine of a main recognition process in the control of the mounting operation carried out by the component mounting machine according to figure 1,
Figure 8 is an explanatory view showing the rotating operation of the chip component during the component recognition process, said component being placed in a detection area of the laser unit shown in figure 4,
Figure 9 is a flow chart showing another example of the routine of the main recognition process in the control of the mounting operation carried out by the mounting machine according to figure 1,
Figure 10 is a time chart showing the timing of the mounting operations including an attracting operation and the recognition process for two components attracted to two attracting nozzles,
Figure 11 is a flow chart showing an example of the control of the mounting operation,
Figure 12 is a time chart showing the time relation of the attracting operation, component recognition process and mounting operation based on the prior art.

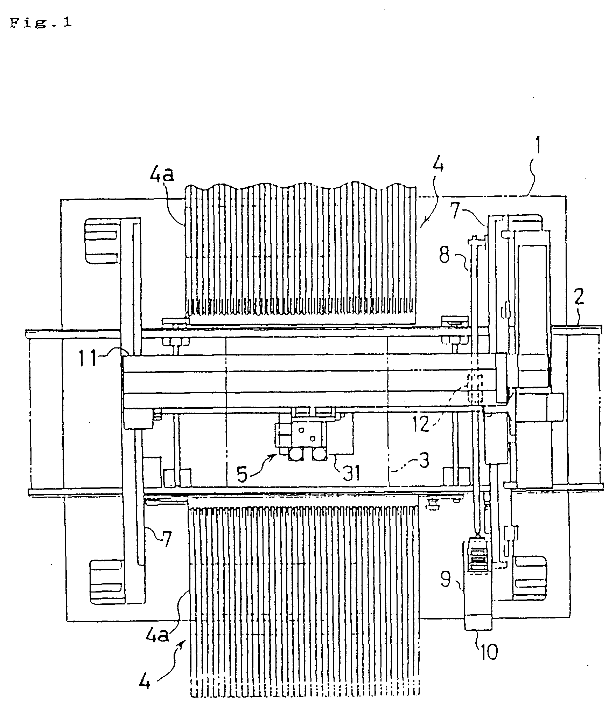

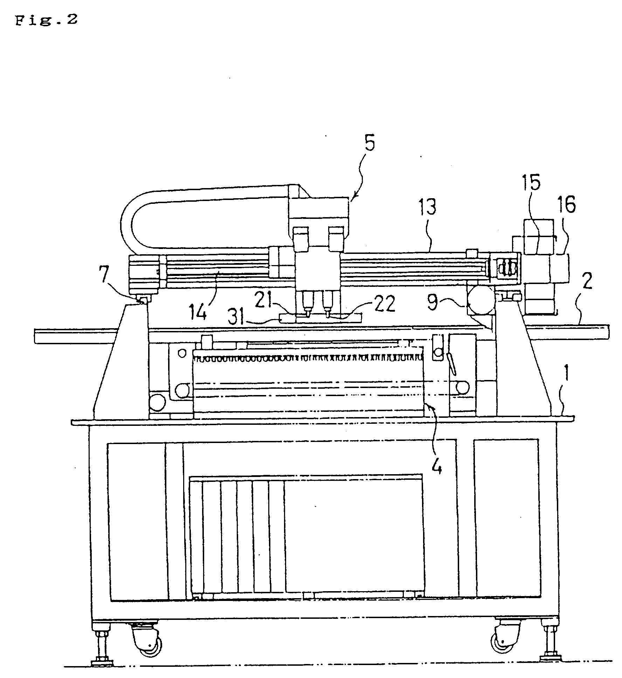

Fig.1 and Fig.2 show the overall structure of a component mounting machine, an embodiment of this invention. As shown, a conveyer 2 for conveying printed substrates is installed on the base 1, the printed substrate is conveyed on the conveyer 2, and is brought to a stop at a predetermined component mounting position.

On the sides of the conveyer 2 are disposed component feeding sections 4 each provided with many rows of tape feeders 4a. Each tape feeder 4a is adapted for sending out a tape holding and containing chip components 20 such as ICs, transisters, condensers, etc., at regular intervals from a reel, and is provided with a ratchet type feeder mechanism incorporated at the tape send-out end so that the feeder tape 4a may be intermittently sent out as chip components are picked up by a head unit 5 to be described later.

The head unit 5 adapted for moving both in the X axis direction (direction of the conveyer 2) and in the Y axis direction (direction perpendiclar to the X axis direction on a horizontal plane) is installed above the base 1.

That is, while a pair of fixed rails 7 extended in the Y axis direction and a ball screw 8 to be rotated by a Y axis servomotor 9 are disposed on the base 1, a head unit support member 11 is supported on the fixed rails 7, and a nut portion 12 provided on the support member 11 is in screw-engagement with the ball screw 8. The supporting member 11 is provided with a guide member 13 extended in the X-axis direction and a ball screw 14 to be rotated by an X axis servomotor 15, a head unit 5 is movably supported by the guide member 13, and a nut portion (not shown) provided in this head unit 5 is in screw-engagement with the ball screw 14. While the ball screw 8 is rotated by the operation of the Y axis servomotor 9 and the support member 11 is moved in the Y axis direction, the ball screw 14 is rotated by the operation of the X axis servomotor 15 and the head unit 5 is moved in the X axis direction relative to the support member 11.

The Y axis servomotor 9 and X axis servomotor 15 are respectively provided with position detecting means 10 and 16 each constituted of an encoder.

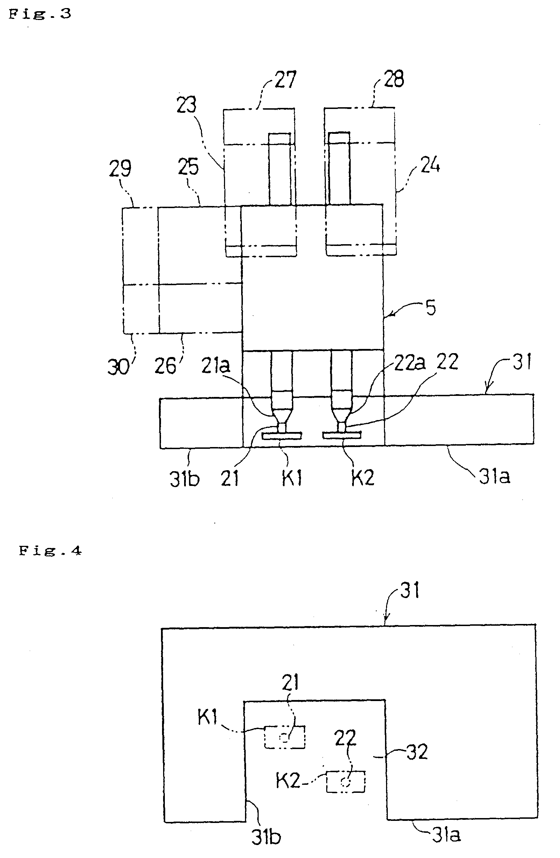

The head unit 5 is provided with a plurality of attracting nozzles and driving means for vertically transferring and rotating each attracting nozzle. As shown also in Fig.3, this embodiment is provided, on the head unit 5, with first and second attracting nozzles 21 and 22, two Z-axis servomotors as driving means for vertically transferring each attracting nozzle 21,22, and two R-axis servomotors as driving means for rotating each attracting nozzle 21,22.

The attracting nozzles 21,22 are installed on the lower ends of their hollow nozzle shafts 21a,22a, the nozzle shafts 21a,22a are mounted on their respective housings (not shown) in a state capable of vertically sliding but incapable of rotating relative to each other, and each housing is rotatably held on the frame of the head unit 5; thus, each attracting nozzle 21,22 is made capable of transferring in the Z-axis (vertical) direction and rotating about the R-axis (nozzle axis). Further, each nozzle shaft 21a,22a is driven in the Z-axis direction by each Z-axis servomotor 23,24 through transmission means (not shown), and each housing above is driven for rotation by each R-axis servomotor through transmission means (not shown).

The servomotors above 23 through 26 are provided with position detecting means 27 through 30, respectively. Each nozzle shaft 21a,22a is connected to negative pressure supplying means (not shown) through valves, etc., so that the negative pressure for component attraction is supplied when required.

On the lower end portion of the head unit 5 is disposed a laser unit 31 as optical detecting means for detecting the projections of the chip components K1,K2 attracted to the attracting nozzles 21,22. This laser unit 31 has a laser generating section (parallel light beam emitting section) 31a and a detector (light receiving section) 31b, and this laser generating section 31a and the detector 31b are disposed opposite to each other on both sides of a space in which the chip components K1 and K2 attracted to the attracting nozzles 21 and 22 are located while being recognized. The detector 31b is constituted of a CCD.

The attracting nozzles 21 and 22 are disposed aslant relative to the laser emitting direction and are spaced apart by a predetermined distance, so that the projections of the chip components K1 and K2 attracted to the attracting nozzles 21 and 22 do not overlap with each other.

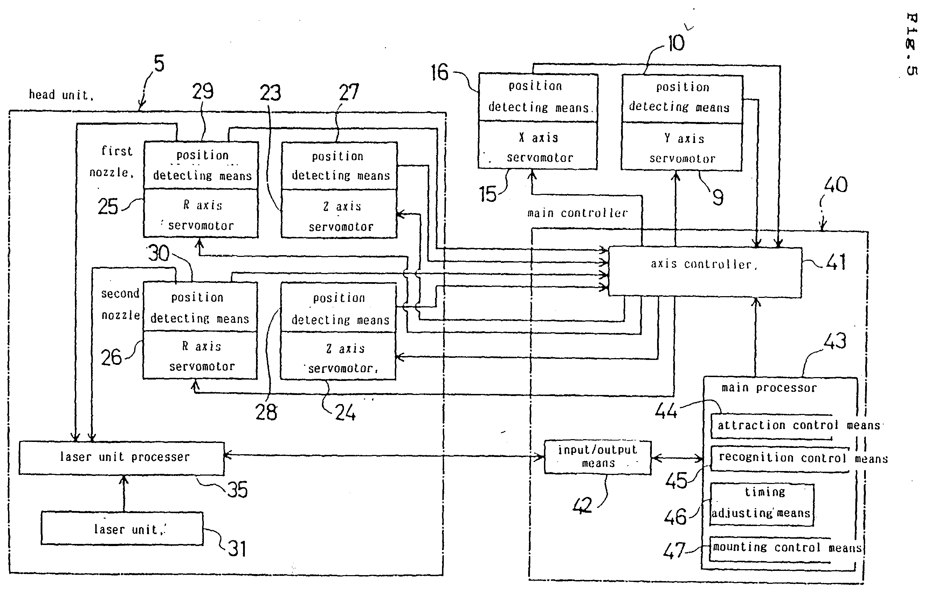

Fig.5 shows an embodiment of the control system. In this diagram, the component mounting machine is provided with a main controller 40, which is provided with an axis controller (driver) 41, input/output means 42, and a main processor 43.

The Y-axis servomotor 9, X-axis servomotor 15, Z-axis servomotors 23,24 for attracting nozzles 21,22 of the head unit 5, R-axis servomotors 25,26, and position detecting means 10,16,27 through 30 provided for these servomotors are electrically connected to the axis controller 41 of the main controller 40. The operations of the servomotors 9, 15 and 23 through 26 are controlled by this axis controller 41.

The laser unit 31 is electrically connected to the laser unit processor (calculation processing means) 35 so that the calculation process of the component recognizing informations such as the component projection width, nozzle rotation angle, etc., are carried out by this laser unit processor 35 on the basis of outputs of the laser unit 31 and position detecting means 29,30. This laser unit processor 35 is connected to the main processor 43 through the input/output means 42 of the main processor 40. In this embodiment, it is difficult for the laser unit processor 35, because of its capability, to start calculation of the projection width of another chip component while calculating the projection width, etc., of a component (that is, to carry out respective calculations partly in overlap with each other), and it is required to carry out calculations for respective chip components in their perfectly lagged period. Such a laser unit processor 35 is what is generally used in this kind of recognizing system.

The main processor 43 controls the operations of the servomotors 9, 15, 23 through 26 through the axis controller 41 so that the chip component is automatically attracted, recognized and mounted, and carries out processes such as reading the informations from the laser unit processor 35 through the input/output means 42. Since this main processor 43 controls according to such a program as shown in the flow chart (to be described later), it will functionally include the attraction control means 44, recognition control means 45, timing adjusting means 46 and mounting control means 47.

That is, the attraction control means 44 controls the operations of the head unit 5 and the attracting nozzles 21 and 22 so that they attract chip components from the tape feeder 4a of the component feeding section 4, and, in this embodiment, makes the attracting nozzles 21 and 22 attract chip compoents successively.

The recognition control means 45 carries out, for each of the components K1 and K2 attracted to each attracting nozzle 21 and 22, the component recognition process including the process of actuating the R-axis servomotors 25 and 26 to rotate the attracting nozzles 21 and 22 after the components are attracted and the process of recognizing the chip component attracting state on the basis of the informations obtained from the laser unit processor 35 while rotating the attracting nozzles. In this embodiment, as the component recognition process, the process of recognizing the chip component attracting state on the basis of the informations obtained from the laser unit 35 is carried out while rotating the attracting nozzles in the sense for recognition after the preliminary rotation process in which the attracting nozzles are rotated in a sense contrary to that for recognition is carried out.

The timing adjusting means 46 adjust the timing of the component recognition process so that the period of the component recognition process for the component attracted to one attracting nozzle at least partly overlap with the period of the component recognition process for the component attracted to the other attracting nozzle; in this embodiment, while the component recognition process is being carried out for the component attracted to the first attracting nozzle 21, the preliminary rotation of the component already attracted to the second attracting nozzle 22 is started.

The mounting control means 37 controls the operations of the head unit 5 and attracting nozzles 21 and 22 so that chip component is mounted at the predetermined position on the printed substrate.

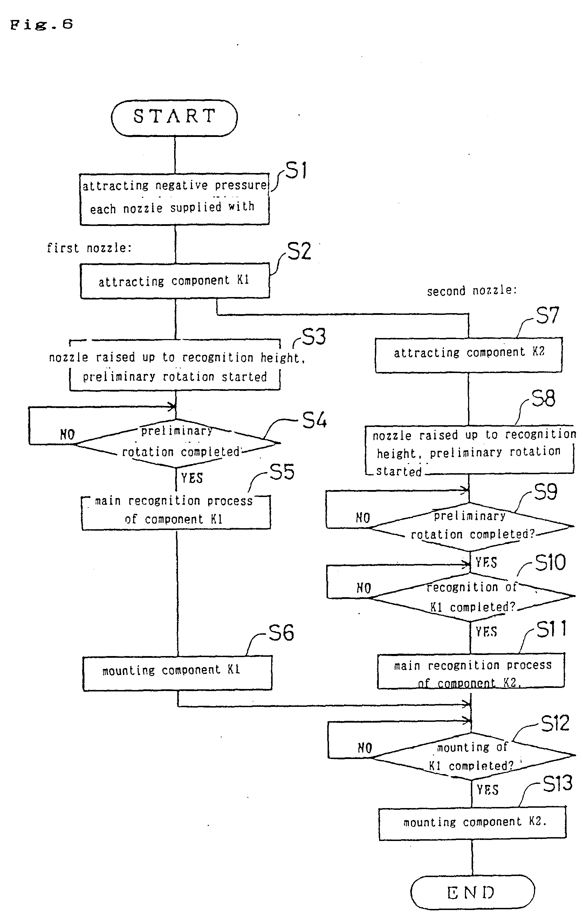

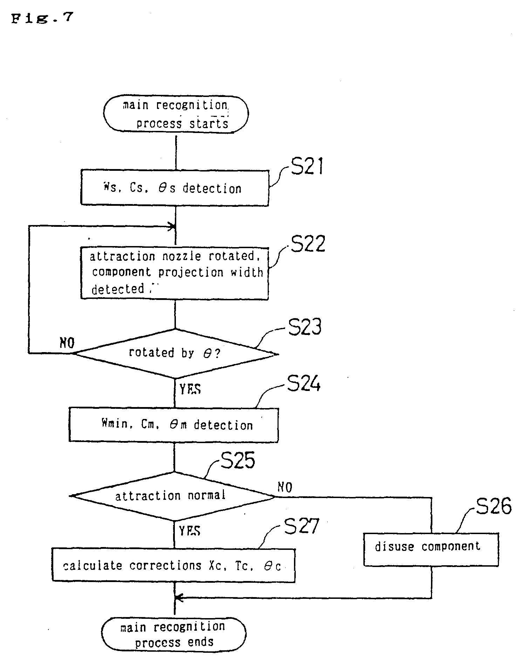

An example of controls by the main controller 40 is described practically referring to the flow charts shown in Figs.6 and 7. In the following description for the flow charts, the preliminary rotation and the main recognition operation are described assuming that the chip component is oblong, and the chip component as attracted and the laser unit are in a positional relation that the longer side of the chip component is generally parallel to the laser beam within a definite rotation angle error. However, the shorter side and the longer side of the chip component may be positioned contrariwise, or may be two sides of a generally square chip component.

As seen in Fig.6, when the mounting operation is started, each attracting nozzle 21,22 is supplied with attracting negative pressure at the step S1, and a chip component K1 is attracted to the first attracting nozzle 21 at the step S2. Describing more practically, in this attracting operation, the head unit 5 is transferred to above the component feeding section 4; when the head unit 5 reaches the position where the attracting nozzle 21 corresponds to the tape feeder 4a, the attacting nozzle 21 is lowered and attracts the chip component K1.

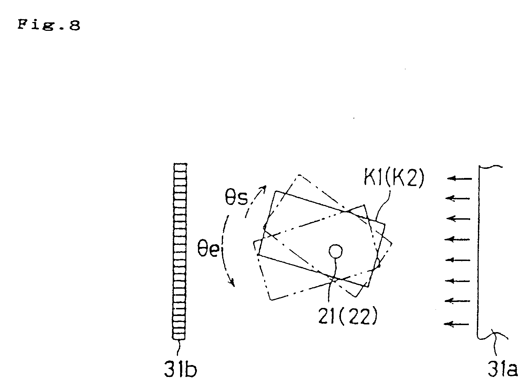

When the attracting operation by the first attracting nizzle 21 is completed, at the step S3, the first attracting nozzle 21 is raised up to a predetermined recognition height corresponding to the laser unit 31, and the preliminary rotation of the first attracting nozzle 21 is started. Practically saying, by this preliminary rotation, as shown in Fig.8, the attracting nozzle 21 attracting a chip component K1 is rotated by a definite angle θs in a sense contrary to that for recognition rotation (clockwise in Fig.8) as shown with dash-and-single-dotted lines. By this preliminary rotation, a state of the chip component K1 is securely obtained in which its longer side is inclined toward a definite side relative to the laser beam direction, and this state is taken as the initial position for carrying out the main recognition process.

In succession, at the step S4, it is judged whether the preliminary rotation of the first attracting nozzle 21 is completed or not. When the preliminary rotation is completed, the operation proceeds to the step S5, and the main recognition process for the chip component K1 atttracted to the first attracting nozzle 21 is carried out as described in detail later.

On the other hand, after the completion of the attracting operation by the first attracting nozzle 21, the attracting operation by the second attracting nozzle 22 is carried out at the step S7 in the same manner as the attracting operation by the first attracting nozzle 21, and, when this attracting operation is completed, at the step S8, the second attracting nozzle 22 is raised up to a predetermined recognition height corresponding to the laser unit 31, and the preliminary rotation of the second attracting nozzle 22 (the same as the preliminary rotation of the first attracting nozzle 21) is started. The attracting operation and the preliminary rotation of the second attracting nozzle 22 are carried out in parallel with the steps S3 through S5 on the first attracting nozzle 21 side.

Then, at the step S9, it is judged whether the preliminary rotation of the second attracting nozzle 22 is completed or not. When this preliminary rotation is completed, at the step S10, it is judged whether the recognition of the chip component K1 attracted to the attracting nozzle 21 (process at the step S4 above) is completed or not. When it is judged that the recognition of the chip component K1 is completed, the operation proceeds to the step S11, and the main recognition process for the chip component K2 attracted to the second attracting nozzle 22 is carried out as described in detail later.

As the process after the main recognition process (step S5) on the first attracting nozzle 21 side, the chip component K1 is mounted at the step S6. Practically, by transferring the head unit 5 to the target position above the printed substrate 3, lowering the first attracting nozzle 21 and intercepting the negative pressure supply, the chip component K1 is mounted on the printed substrate 3. On the other hand, as the processes after the main recognition process (step S11) on the second attracting nozzle 22 side, at the step S12, it is judged whether the mounting operation of the chip component K1 by the attracting nozzle 21 is completed or not, then, when completed, the operation proceeds to the step S13, and the mounting operation of the chip component K2 by the second attracting nozzle 22 (the same as the mounting operation by the first attracting nozzle 21) is carried out.

Fig.7 is a flow chart showing the routine of the main recognition process to be carried out at each of the steps S5 and S11 above. At the step S21 in this routine, the projection width Ws, center position Cs and rotation angle θs of the chip component at the instance when the preliminary rotation above is completed are detected. In succession, the attracting nozzle is rotated from its initial position shown in Fig.8 with dash-and-double-dotted lines in the predetermined direction for the recognition rotation (anticlockwise in Fig.8) by a definite angle θe, and, while the attracting nozzle is being thus rotated, the projection width W of the chip component is detected repeatedly (steps S22, S23). This chip component projection width W is given by the calculation at the laser unit processor 35 on the basis of the output of the laser unit 31.

At the step S24, while the minimum projection width Wmin is obtained from the data of the projection width W above, the center position Cm and the rotation angle θm (rotation angle referred to the position before the preliminary rotation) are detected. That is, while the chip component attracted to the attracting nozzle is being rotated, the projection width becomes minimum when the longer side of the chip component is directed in the same direction as the laser beam direction, and the projection width Wmin (corresponding to the length of the shorter side of the chip component), center position Cm and the rotation angle θm at this instance are detected.

In succession, at the step S25, it is judged on the basis of the data above, etc., whether the component attraction is normal or not. Here, the attraction is judged to be normal if, for example, the value corresponding to the component shorter side length obtained from the projection width Wmin above and the value corresponding to the component longer side length obtained by calculation from the above or other data are sufficiently approximate to the actual lengths of the shorter and longer sides of the chip component and the rotation angle θm is in the predetermined range, and is judged to be defective if not. When not normal (when the attraction is defective), the operation proceeds to the step S26 and the chip component concerned is disused; when the attraction is normal, the operation proceeds to the step S27. At the step S27, the length of the chip component shorter side, the deviation of the component center from the nozzle center in the shorter side direction and the rotation angle deviation are obtained from the projection width Wmin above, center position Cm and the rotation angle θm. Further, from these and other data, the length of the component longer side and the deviation of the component center from the nozzle center in the longer side direction are obtained by calculation, and from these are calculated the mounting position correction amounts Xc, Yc and θc. When the chip component is mounted at the step S6 or S13 in Fig.6, the target mounting position is corrected by these correction amounts Xc, Yc and θc.

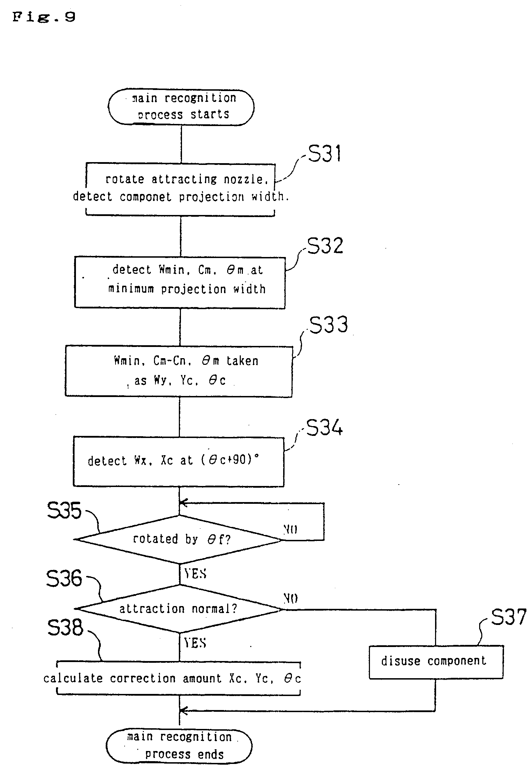

Although the length of one side (shorter side) of the attracted component is obtained from the minumum projection width Wmin while the length of the other side (longer side) is obtained by calculation in an example of the main recognition process shown in Fig.7, the lengths of the longer and shorter sides may be obtained both from the detected projection width as shown in Fig.9 as another example of the main recognition process.

The process of Fig.9 is described hereafter. After the preliminary rotation, while the attracting nozzle is being rotated in the component recognition direction at the step S31, the projection width W of the chip component is detected. Then, the rotational position at which the projection width becomes minimum is obtained, the projection width Wmin, component center position Cm and the rotation angle θm (rotation angle referred to the position before the preliminary rotation) at that instance are detected at the step S32, and the projection width Wmin above, the difference (Cm-Cn) between the component center position Cm and the nozzle center position Cn above, and the rotation angle θm above are taken as the projection width Wy corresponding to the component shorter side length, positional deviation Yc in the Y axis direction and the rotation angle deviation θc, respectively, at the step S33.

Next, the projection width and the component center position at the instance when the attracting nozzle is rotated up to the rotation angle of ( θc + 90° ) are detected, and the projection width above and the difference between the component center position and the nozzle center position are taken as the projection width Wx corresponding to the component longer side length, and the positional deviation Xc in the X-axis direction, respectively, at the step S34. Then, after the attracting nozzle is rotated at the step S35 up to a set rotation angle θf which makes such detections possible, the attraction is judged to be normal or not at the step S36 in the same manner as at the step S25 in Fig.7, and, if not normal, the chip component is disused at the step S37. When the attraction is normal, correction amounts are obtained with the Y-axis direction positional deviation Yc, rotational angle deviation θc and the X axis direction positional deviation Xc above at the step S38.

Comparing the case according to the example of Fig.7 with the case according to the example of Fig.9, when the chip component is smaller, since the error of the calculated value may become larger when the chip component longer side length is obtained by calculation as in Fig.7 due to errors included in the data for the calculation, higher accuracy is obtained when both side lengths are obtained by projection width detection as shown in Fig.9. On the other hand, when the chip component is larger, since a larger positional deviation of the component may happen during its rotation if the component is rapidly rotated through a large rotation angle, the method in which the attracting nozzle rotation angle for the projection width detection is made smaller and the chip component longer side length is obtained by calculation as shown in Fig.7 is advantageous for the accuracy. Therefore, it is effective to selectively employ the process as shown in Fig.7 or the process as shown in Fig.9 according to the kind of chip components.

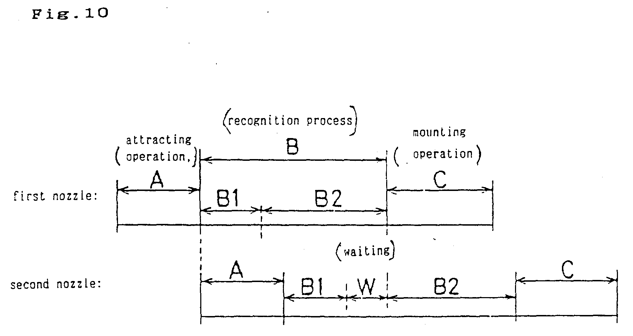

When employing such apparatus as described above, the time chart for the attracting operation using the attracting nozzles 21 and 22, component recognition process and mounting operation is as shown in Fig.10. In Fig.10, A, B, B1, B2, C, and W indicate the period for attracting operation, component recognition process, preliminary rotation in the component recognition process, main recognition precess in the component recognition process, and mounting operation, respectively.

As shown in this time chart, on the first nozzle side, the attracting operation for the chip component K1, the recognition process B of the chip component K1 including the preliminary rotation B1 and the main recognition process B2, and the mounting operation C1 for the chip component K1 are carried out in succession.

On the second nozzle side, the attracting operation A is started after the attracting operation on the first nozzle side is completed. Although the attracting operation A and preliminary rotation B1, main recognition process B2 and mounting operation C for the chip component K2 are carried out in succession also on this second nozzle side, the attracting operation A and the preliminary rotation B1 among them are carried out in time overlap with the recognition process on the first nozzle side. Further, if the recognition process B on the first nozzle side is not yet completed when the preliminary rotation B1 on the second nozzle side is completed, the main recognition process B2 and the mounting operation C on the second nozzle side are carried out after a lapse of waiting period W until the recognition process B on the first nozzle side is completed.

Hereupon, in the recognition process for the chip components K1 and K2, since preliminary rotation B1 is carried out before the main recognition process B2, the chip component K1 at the start of the main recognition process is surely in a state inclined toward a definite side relative to the laser beam. Therefore, the minimum projection width Wmin can be surely detected while the attracting nozzle is rotated by a definite angle θe during the main recognition process, and the component attracting state can be recognized rapidly and accurately.

Further, although the laser unit processor 35 is not capable of calculating the projection widths, etc., for a plurality of components in partial overlap with each other, since it is not required to calculate the projection widths, etc., during the preliminary rotation above, even if the period of preliminary rotation on the second attracting nozzle side overlaps with that of the recognition process on the first attracting nozzle side, there is no trouble for the calculation at the laser unit processor 35 if the main recognition processes does not overlap with each other. Thus, since the preliminary rotation in the recognition process on the second attracting nozzle side is carried out during the recognition process on the first attracting nozzle side, the period of waiting W on the second nozzle side becomes shorter than that in the former case (see Fig.12), the time loss during the mounting operation from attraction to mounting is reduced and the mounting time is shortened.

Although the attracting operations of the attracting nozzles 21 and 22 in the embodiment above are so controlled, as an example for the case where simultaneous attractions are difficult, that the attraction by the second nozzle 22 is carried out after the attraction by the first nozzle 21 is completed, simultaneous attractions may be possible according the the positional relation between the attracting nozzles 21,22 and the tape feeder 4a of the component feeder section 4. In such a case, the attracting operation may be controlled as shown in the flow chart of Fig.11.

In the example shown in Fig.11, after both attracting nozzles 21,22 are supplied with attracting negative pressure at the step S101, the attraction of the component K1 by the first attracting nozzle 21 (step S102) and the attraction of the component K2 by the second attracting nozzle 22 (step S107) are simultaneously carried out in parallel, and both attracting nozzles are raised and preliminarily rotated in parallel (steps S103 and S108). Thereafter, the judgement of completion of the preliminary rotation on the first nozzle side (step S104), and the main recognition process (step S105) and mounting operation (step S106) of the chip component K1, the judgement of completion of the preliminary rotation on the second nozzle side (step S109), the judgement of completion of recogintion process of the chip component K1 (step S110), the main recognition process of the chip component K2 (step S111), judgement of completion of mounting operation of the chip component K1 (step S112) and the mounting operation of the chip component K2 (step S113) are the same as the steps S4 through S6 and steps S9 through S13 in the flow chart of Fig.6.

With this embodiment also, since the preliminary rotation in the recognition process on the second attracting nozzle is carried out while the recognition process on the second attracting nozzle side is being carried out, the time loss is reduced. This embodiment is further advantageous for shortening the mounting time because attractions are carried out simultaneously by a plurality of attracting nozzles.

The embodiments above can be modified without changing the purport of this invention.

For example, although the embodiment above is adapted to the case where the laser unit processor 35 is not capable of calculating the projection widths, etc., for a plurality of components in partial overlap with each other, when the laser unit processor 35 is capable of calculating the projection widths, etc., for a plurality of components in overlap with each other, both component recognition processes on the first nozzle side and on the second nozzle side may be overlapped with each other with their main recognition processes included.

Further, the number of attracting nozzles equipped on the head unit 5 may be three or more.

According to the described embodiment, on a chip component mounting machine having a head unit provided with a plurality of attracting nozzles, since it is provided. with optical detecting means for detecting the projections of the chip components attracted to the attracting nozzles,calculatig means for calculating the projection width of the chip component attracted to the attracting nozzle on the basis of the output of the optical detecting means,recognition control means for rotating the attracting nozzle attracting a chip component and carrying out the chip component recognition process for the chip component attracted to each attracting nozzle on the basis of the information obtained from the calculating means during the rotation of the attracting nozzle, and timing adjusting means for adjusting the timings of component recognition processes so that the periods of the component recognition processes for components attracted to respective attracting nozzles at least partly overlap with each other, the time lag between the component recognition processes for the components of respective attracting nozzles becomes smaller. Therefore, the time loss during the mounting operation can be reduced and the mounting time can be shortened.

According to the described embodiment of this invention, as the component recognition process by the recognition control means especially on this mounting machine, the main recognition process for recognizing the chip component attracting state is carried out while rotating the attracting nozzle in the sense for recognition after carrying out the preliminary rotation in which the attracting nozzle is rotated by a predetermined angle in a sense contrary to the predetermined sense for recognition rotation, and the timing is so adjusted by the timing adjusting means above that, while the component recognition process for one attracting nozzle is being carried out, the preliminary rotation in the component recognition process for the attracting component of the other attracting nozzle is carried out. Thus, the main recognition process can be carried out rapidly and accurately due to the preliminary rotation above. Further, even when it is difficult to carry out the projection width calculation, etc., simultaneously for a plurality of chip components because of the capacity of the calculating means, the time lag between the component recognition processes for attracting components of the resp ective attracting nozzles can be made smaller and the mounting time can be shortened within a range not causing a trouble.

Further, when the components are successively attracted to the respective attracting nozzles it is possible, in succession to the chip component attraction by a first attracting nozzle, while the component recognition process for the attracting component of the first attracting nozzle is being carried out, to carry out the chip component attraction by the second attracting nozzle and also part of component recognition process continuing to the attraction above, which is effective for reducing the time loss.

To make the components be attracted simultaneously to a plurality of attracting nozzles is more advantageous for shortening the mounting time.

## Claims

1. Method for mounting components (K1,K2) at specific positions, especially chip components onto a substrate such as a printed circuit board, the method comprising the steps of picking up the components (K,K2) through a plurality of attracting nozzle units (21,22), transferring the components (K1,K2) and placing the same in a detection area of an optical detecting means (31) emitting light beams for detecting a projected width (W) of the components (K1,K2), subjecting the components (K1,K2) to a recognition process each, for recognising the components and/or their positions relative to the attracting nozzle units (21,22), said recognition process (B) including a preliminary rotation (B1) of the components (K1,K2) and a main recognition process (B2) wherein projected width data (Wm, Cm, θm) are obtained under rotation of the components (K1,K2) and wherein the projections of the components (K1,K2) attracted to the attracting nozzle units (21,22) do not overlap with each other, and mounting the components (K1,K2) at the desired positions **characterised in that** the timing of the recognition processes (B) for a plurality of components (K1,K2) is adjusted by a timing adjusting means (46) in response to each other, such that a recognition process (B) for a first component (K1) overlaps at least partly a recognition process (B) for another component (K2).

2. Method according to claim 1, **characterised in that** said timing is adjusted in such a manner that while the recognition process (B) for said first component (K1) is carried out, the preliminary rotation (B1) of at least another component (K2) is performed.

3. Method according to claim 1 or 2, **characterised in that** the timings of the preliminary rotation (B1) and the main recognition process (B2) of said other component (K2) are adjusted to have a waiting period (W) between each other, said waiting period (W) corresponding to the period between the end of the preliminary rotation (B1) of said other component (K2) and the end of the main recognition process (B1) of said first component (K1).

4. Method according to at least one of claims 1 to 3, **characterised in that** the timings of the main recognition processes (B2) for a plurality of components (K1,K2) are adjusted such that said main recognition processes (B2) are performed in succession, said main recognition processes (B2) are not overlapping each other.

5. Method according to at least one of claims 1 to 4, **characterised in that** the pick up process (A) of the components (K1,K2) is controlled by an attraction control means (44), such that the components (K1,K2) are picked up in succession.

6. Method according to at least one of claims 1 to 4, **characterised in that** the pick up process of the components (K1,K2) is controlled by an attraction control means (44), such that the components (K1,K2) are picked up simultaneously.

7. Method according to at least one of claims 1 to 6, **characterised in that** the timing of the preliminary rotation (B1) is adjusted to be carried out substantially immediately after the pick up process (A) of the respective component (K1,K2).

8. Mounting device for mounting components (K1,K2) at specific positions, especially chip components onto a substrate such as a printed circuit board, the mounting device comprising a moveable mounting head unit (5) having a plurality of attracting nozzle units (21,22) for picking up components (K1,K2) from a component supply unit (4), an optical detecting means (31) emitting light beams for detecting a projected width (W) of said components (K1,K2), a control unit (40) for controlling the mounting head unit (5) including recognition control means (45) for controlling recognition processes (B) for recognising the components (K1,K2) and/or the positions thereof relative to the attracting nozzle units (21,22), wherein the projections of the components (K1,K2) attracted to the attracting nozzle units (21,22) do not overlap with each other **characterised in that** said control unit (40) includes timing adjusting means (46) for adjusting the timings of the recognition processes (B) for a plurality of components (K1,K2) in response to each other such that said recognition processes (B) overlap each other at least partly.

9. Mounting device according to claim 8, **characterised in that** the recognition control means (45) is adapted to preliminarily rotate the attracting nozzle units (21,22) with the components (K1,K2) attracted thereto from their initial positions by a certain angle (θs) about a rotational axis (R) into preliminary positions, and, in a main recognition process (B2), from said preliminary positions about said axis (R) by a certain angle (θe) in the direction contrary to the preliminary rotation (B1), for recognising the components (K1,K2) and/or the positions thereof on the basis of projected width data (Wm, Cm,θm) obtained during rotation.

10. Mounting device according to claim 9, **characterised in that** said timing adjusting means (46) is adapted to adjust the timing of the recognition processes (B) such that, while the recognition process (B) for a first component (K1) is performed, the preliminary rotation (B1) of at least another component (K2) is carried out.

11. Mounting device according to at least one of claims 9 to 10, **characterised in that** the timing adjusting means (46) is adapted to adjust the timing of a plurality of main recognition processes (B2) for a plurality of components (K1,K2) such that the same are performed in succession.

12. Mounting device according to at least one of claims 8 to 11, **characterised in that** the control unit (40) includes attraction control means (44) for controlling the attracting nozzle units (21,22).

13. Mounting device according to claim 12, **characterised in that** said attraction control means (44) is adapted to control the attracting nozzle units (21,22) such that a plurality of components (K1,K2) are picked up in succession.

14. Mounting device according to claim 12, **characterised in that** said attraction control means (44) is adapted to control the attracting nozzle units (21,22) such that a plurality of components (K1,K2) are picked up simultaneously.

15. Mounting device according to at least one of claims 9 to 11, **characterised in that** the timing adjusting means (46) is adapted to adjust the timing of the preliminary rotation (B1) and the main recognition process (B2) of said other component (K2) such that a waiting period (W) lies between said preliminary rotation (B1) and said main recognition process (B2), said waiting period (W) corresponding to the period between the end of said preliminary rotation (B1) of the other component (K2) and the main recognition process (B2) of said first component (K1).

## Patentansprüche

1. Verfahren zum Montieren von Bauteilen (K1,K2) an bestimmten Positionen, insbesondere von Chipbauteilen auf einem Substrat, wie z.B. einer gedruckten Leiterplatte, wobei das Verfahren die Schritte aufweist des Aufnehmens der Bauteile (K1,K2) durch eine Mehrzahl von Anziehungsdüseneinheiten (21,22), des Transferierens dieser Bauteile (K1,K2) und des Anordnens derselben in einem Erfassungsbereich einer optischen Erfassungseinrichtung (31), die zur Erfassung einer projizieerten Breite (W) der Bauteile (K1,K2) Lichtstrahlen emittiert, des Unterziehens jedes dieser Bauteile (K1,K2) einem Erkennungsprozeß, zur Erkennung der Bauteile und/oder ihrer Lagen relativ zu den Anziehungsdüseneinheiten (21,22), wobei der Erkennungsprozeß (B) eine vorbereitende Rotation (B1) der Bauteile (K1,K2) und einen Haupterkennungsprozeß (B2) enthält, in dem Daten (Wm,Cm,θm) der projizierten Breite unter Rotation der Bauteile (K1,K2) erhalten werden und wobei die Projektionen der Bauteile (K1,K2), die an den Anziehungsdüseneinheiten (21,22) anhaften, einander nicht überlappen, und des Montierens der Bauteile (K1,K2) an den gewünschten Positionen, **dadurch gekennzeichnet,** daß der Zeitpunkt für die Erkennungsprozesse (B) für eine Mehrzahl von Bauteilen (K1,K2) durch eine Zeitpunkt-Einstelleinrichtung (46) in Abhängigkeit voneinander derart eingestellt wird, daß ein Erkennungsprozeß (B) für ein erstes Bauteil (K1) zumindest teilweise mit einem Erkennungsprozeß (B) für ein anderes Bauteil (K2) überlappt.

2. Verfahren nach Anspruch 1, **dadurch gekennzeichnet,** daß der Zeitpunkt derart eingestellt wird, daß während des Erkennungsprozesses (B) für das erste Bauteil (K1) ausgeführt wird, die vorbereitende Rotation (B1) von mindestens einem weiteren Bauteil (K2) durchgeführt wird.

3. Verfahren nach Anspruch 1 oder 2, **dadurch gekennzeichnet,** daß die Zeitpunkte der vorlälufigen Rotation (B1) sowie des Haupterkennungsprozesses (B2) dieses anderen Bauteils (K2) so eingestellt wird, daß zwischen diesen eine Warteperiode (W) vorliegt, wobei diese Warteperiode (W) der Periode zwischen dem Ende der vorläufigen Rotation (B1) von diesem anderen Bauteil (K2) und dem Ende des Haupterkennungsprozesses (B1) von besagtem ersten Bauteil (K1) entspricht.

4. Verfahren nach zumindest einem der Ansprüche 1 bis 3, **dadurch gekennzeichnet,** daß die Zeitpunkte der Haupterkennungsprozesse (B2) für eine Mehrzahl von Bauteilen (K1,K2) derart eingestellt wird, daß die Haupterkennungsprozesse (B2) in Abfolge durchgeführt werden, wobei diese Haupterkennungsprozesse (B2) einander nicht überlappen.

5. Verfahren nach zumindest einem der Ansprüche 1 bis 4, **dadurch gekennzeichnet,** daß der Aufnahmeprozeß(A)der Bauteile (K1,K2) von einer Anziehungs-Steuereinrichtung (44) derart gesteuert wird, daß die Bauteile (K1,K2) gleichzeitig aufgenommen werden.

6. Verfahren nach mindestens einem der Ansprüche 1 bis 4, **dadurch gekennzeichnet,** daß der Aufnahmeprozeß der Bauteile (K1,K2) von einer Anziehungs-Steuereinrichtung (44) derart gesteuert wird, daß die Bauteile (K1,K2) gleichzeitig aufgenommen werden.

7. Verfahren nach mindestens einem der Ansprüche 1 bis 6, **dadurch gekennzeichnet,** daß der Zeitpunkt der vorbereitenden Rotation (B1) so eingestellt wird, daß diese im wesentlichen unmittelbar nach dem Aufnahmeprozeß (A) des entsprechenden Bauteils (K1,K2) erfolgt.

8. Montagevorrichtung zum Montieren von Bauteilen (K1,K2) an bestimmten Positionen, insbesondere von Chipbauteilen auf einem Substrat, wie z.B. einer gedruckten Leiterplatte, wobei die Montagevorrichtung aufweist eine bewegbare Montagekopfeinheit (5), die eine Mehrzahl von Anziehungsdüseneinheiten (21,22) aufweist, zum Aufnehmen der Bauteile (K1,K2) von einer Bauteilzuführeinheit (4) enthält, eine optische Erfassungseinrichtung (31), die zur Erfassung einer projizierten Breite (W) dieser Bauteile (K1,K2) Lichtstrahlen emittiert, eine Steuereinheit (40) zur Steuerung der Montagekopfeinheit (5), die eine Erkennungs-Steuerungseinrichtung (45) aufweist zur Steuerung von Erkennungsprozessen (B) für die Erkennung der Bauteile (K1,K2) und/oder deren Positionen relativ zu den Anziehungsdüseneinheiten (21,22), wobei die Projektionen der Bauteile (K1,K2), die an den Anziehungsdüseneinheiten (21,22) anhaften, einander nicht überlappen, **dadurch gekennzeichnet,** daß die Steuereinheit (40) eine Zeitpunkt-Einstelleinrichtung (46) enthält, zum Einstellen der Zeitpunkte der Erkennungsprozesse (B) für eine Mehrzahl von Komponenten (K1,K2) in Abhängigkeit voneinander derart, daß die Erkennungsprozesse (B) zumindest teilweise einander überlappen.

9. Montagevorrichtung nach Anspruch 8, **dadurch gekennzeichnet,** daß die Erkennungs-Steuerungseinrichtung (45) ausgelegt ist, die Anziehungsdüseneinheiten (21,22) mit den daran anhaftenden Bauteilen (K1,K2) aus ihren anfänglichen Positionen um einen bestimmten Winkel (θs) um eine Rotationsachse (R) in vorläufige Positionen vorläufig zu drehen, und in einem Haupterkennungsprozeß (B2) aus diesen vorläufigen Positionen heraus um diese Achse (R) um einen bestimmten Winkel (θe) in zu der vorläufigen Rotation (B1) entgegengesetzter Richtung zu drehen, zur Erkennung der Bauteile (K2) und/oder deren Positionen auf der Grundlage der während dieser Rotation erhaltenen Daten (Wm,Cm,θm) der projizierten Breite.

10. Montagevorrichtung nach Anspruch 9, **dadurch gekennzeichnet,** daß die Zeitpunkt-Einstelleinrichtung (46) dazu ausgelegt ist, den Zeitpunkt des Erkennungsprozesses (W) derart einzustellen, daß während der Durchführung des Erkennungsprozesses (B) für ein erstes Bauteil (K1) die vorläufige Rotation (B1) für mindestens ein weiteres Bauteil (K2) durchgeführt wird.

11. Montagevorrichtung nach mindestens einem der Ansprüche 9 bis 10, **dadurch gekennzeichnet,** daß die Zeitpunkt-Einstelleinrichtung (46) dazu ausgelegt ist, die Zeitpunkte einer Mehrzahl von Haupterkennungsprozessen (B2) für eine Mehrzahl von Bauteilen (K1,K2) derart einzustellen, daß diese in Abfolge ausgesführt werden.

12. Montageeinrichtung nach zumindest einem der Ansprüche 8 bis 11, **dadurch gekennzeichnet,** daß die Steuereinheit (40) eine Anziehungs-Steuerungseinrichtung (44) zur Steuerung der Anziehungsdüseneinheiten (21,22) enthält.

13. Montagevorrichtung nach Anspruch 12, **dadurch gekennzeichnet,** daß die Anziehungssteuerungseinrichtung (44) dazu ausgelegt ist, die Anziehungsdüseneinheiten (21,22) derart zu steuern, daß eine Mehrzahl von Bauteilen (K1,K2) in Abfolge aufgenommen werden.

14. Montagevorrichtung nach Anspruch 12, **dadurch gekennzeichnet,** daß die Anziehungssteuerungseinrichtung (44) dazu ausgelegt ist, die Anziehungsdüseneinheiten (21,22) derart zu steuern, daß eine Mehrzahl von Bauteilen (K1,K2) gleichzeitig aufgenommen wird.

15. Montagevorrichtung nach mindestens einem der Ansprüche 9 bis 11, **dadurch gekennzeichnet,** daß die Zeitpunkt-Einstelleinrichtung (46) ausgelegt ist, die Zeitpunkte der vorläufigen Rotation (B1) sowie des Haupterkennungsprozesses (B2) dieses anderen Bauteils (K2) derart einzustellen, daß eine Warteperiode (W) zwischen dieser vorläufigen Rotation (B1) und diesem Haupterkennungsprozeß (B2) vorhanden ist, wobei diese Warteperiode (W) dem Zeitraum zwischen dem Ende dieser vorläufigen Rotation (B1) dieses anderen Bauteils (K2) sowie dem Haupterkennungsprozeß (B2) dieses ersten Bauteils (K1) entspricht.

## Revendications

1. Procédé pour monter des composants (K1, K2) dans des positions spécifiques, en particulier des composants de type puce sur un support tel qu'une carte à circuits imprimés, procédé qui comprend les étapes consistant à saisir les composants (K1, K2) à l'aide d'une pluralité d'unités formant buses d'attraction (21, 22), à transférer les composants (K1, K2) et à les placer dans une zone de détection d'un moyen de détection optique (31) émettant des faisceaux lumineux pour détecter une largeur projetée (W) des composants (K1, K2), à soumettre chacun des composants (K1, K2) à une opération de reconnaissance, pour reconnaître les composants et/ou leur position relative par rapport aux unités formant buses d'attraction (21, 22), ladite opération de reconnaissance (B) comprenant une rotation préliminaire (B1) des composants (K1, K2) et une opération de reconnaissance principale (B2), des données de largeur projetée (Wm, Cm, θm) étant obtenues pendant la rotation des composants (K1, K2) et les saillies des composants (K1, K2) attirés vers les unités formant buses d'attraction (21, 22) ne se chevauchant pas l'une l'autre, et à monter les composants (K1, K2) dans les positions souhaitées, caractérisé en ce que le minutage des opérations de reconnaissance (B) d'une pluralité de composants (K1, K2) est ajusté par un moyen d'ajustement du minutage (46), en réponse les unes aux autres, de sorte qu'une opération de reconnaissance (B) d'un premier composant (K1) chevauche au moins partiellement une opération de reconnaissance (B) d'un autre composant (K2).

2. Procédé selon la revendication 1, caractérisé en ce que le minutage est réglé de façon que, pendant l'exécution de l'opération de reconnaissance (B) dudit premier composant (K1), la rotation préliminaire (B1) d'au moins un autre composant (K2) soit réalisée.

3. Procédé selon la revendication 1 ou 2, caractérisé en ce que les minutages de la rotation préliminaire (B1) et de l'opération de reconnaissance principale (B2) dudit autre composant (K2) sont réglés de façon à avoir un délai d'attente (W) entre chacun d'eux, ledit délai d'attente (W) correspondant au laps de temps qui s'écoule entre la fin de la rotation préliminaire (B1) dudit autre composant (K2) et la fin de l'opération de reconnaissance principale (B1) dudit premier composant (K1).

4. Procédé selon au moins l'une des revendications 1 à 3, caractérisé en ce que les minutages des opérations de reconnaissance principales (B2) de plusieurs composants (K1, K2) sont réglés de façon que lesdites opérations de reconnaissance principales (B2) soient exécutées successivement, lesdites opérations de reconnaissance principales (B2) ne se chevauchant pas les unes les autres.

5. Procédé selon au moins l'une des revendications 1 à 4, caractérisé en ce que l'opération de saisie (A) des composants (K1, K2) est commandée par un moyen de commande d'attraction (44), tel que les composants (K1, K2) soient saisis successivement.

6. Procédé selon au moins l'une des revendications 1 à 4, caractérisé en ce que l'opération de saisie des composants (K1, K2) est commandée par un moyen de commande d'attraction (44), tel que les composants (K1, K2) soient saisis simultanément.

7. Procédé selon au moins l'une des revendications 1 à 6, caractérisé en ce que le minutage de la rotation préliminaire (B1) est réglé de façon qu'elle soit exécutée sensiblement immédiatement après l'opération de saisie (A) du composant respectif (K1, K2).

8. Dispositif de montage pour monter des composants (K1, K2) dans des positions spécifiques, en particulier des composants de type puce sur un support tel qu'une carte à circuits imprimés, dispositif de montage qui comprend une unité formant tête de montage mobile (5) ayant plusieurs unités formant buses d'attraction (21, 22) pour saisir les composants (K1, K2) à partir d'une unité d'alimentation de composants (4), un moyen de détection optique (31) émettant des faisceaux lumineux pour détecter une largeur projetée (W) desdits composants (K1, K2), une unité de commande (40) permettant de commander l'unité formant tête de montage (5) qui comprend un moyen de commande de reconnaissance (45) afin de commander les opérations de reconnaissance (B) pour reconnaître les composants (K1, K2) et/ou leur position relative par rapport aux unités formant buses d'attraction (21, 22), les saillies des composants (K1, K2) attirés vers les unités formant buses d'attraction (21, 22) ne se chevauchant pas les unes les autres, caractérisé en ce que l'unité de commande (40) comprend un moyen d'ajustement du minutage (46) pour ajuster les minutages des opérations de reconnaissance (B) de plusieurs composants (K1, K2), en réponse les unes aux autres, de sorte que lesdites opérations de reconnaissance (B) se chevauchent au moins partiellement les unes les autres.

9. Dispositif de montage selon la revendication 8, caractérisé en ce que le moyen de commande de reconnaissance (45) est adapté pour provoquer une rotation préliminaire des unités formant buses d'attraction (21, 22), avec les composants (K1, K2) attirés par elles, à partir de leur position initiale, selon un certain angle (θs) autour d'un axe de rotation (R), jusqu'aux positions préliminaires, et, dans une opération de reconnaissance principale (B2), à partir desdites positions préliminaires, selon un certain angle (θe) autour dudit axe (R), en sens contraire de la rotation préliminaire (B1), pour reconnaître les composants (K1, K2) et/ou leur position sur la base des données de largeur projetée (Wm, Cm, θm) obtenues pendant la rotation.

10. Dispositif de montage selon la revendication 9, caractérisé en ce que ledit moyen de réglage du minutage (46) est adapté pour régler le minutage des opérations de reconnaissance (B) tel que, pendant l'exécution de l'opération de reconnaissance (B) d'un premier composant (K1), la rotation préliminaire (B1) d'au moins un autre composant (K2) soit exécutée.

11. Dispositif de montage selon au moins l'une des revendications 9 ou 10, caractérisé en ce que le moyen d'ajustement du minutage (46) est adapté pour régler les minutages de plusieurs opérations de reconnaissance principales (B2) pour plusieurs composants (K1, K2), tel que ces opérations soient réalisées successivement.

12. Dispositif de montage selon au moins l'une des revendications 8 à 11, caractérisé en ce que l'unité de commande (40) comprend un moyen de commande d'attraction (44) permettant de commander les unités formant buses d'attraction (21, 22).

13. Dispositif de montage selon la revendication 12, caractérisé en ce que le moyen de commande d'attraction (44) est adapté pour commander les unités formant buses d'attraction (21, 22), tel que plusieurs composants (K1, K2) soient saisis successivement.

14. Dispositif de montage selon la revendication 12, caractérisé en ce que le moyen de commande d'attraction (44) est adapté pour commander les unités formant buses d'attraction (21, 22), tel que plusieurs composants (K1, K2) soient saisis simultanément.

15. Dispositif de montage selon au moins l'une des revendications 9 à 11, caractérisé en ce que le moyen de réglage du minutage (46) est adapté pour régler les minutages de la rotation préliminaire (B1) et de l'opération de reconnaissance principale (B2) dudit autre composant (K2), de sorte que le délai d'attente (W) s'étend entre ladite rotation préliminaire (B1) et ladite opération de reconnaissance principale (B2), ledit délai d'attente (W) correspondant au laps de temps qui s'écoule entre la fin de ladite rotation préliminaire (B1) de l'autre composant (K2) et l'opération de reconnaissance principale (B2) dudit premier composant (K1).
